Europäisches Patentamt

European Patent Office

Office européen des brevets

(19)

(11) Publication number: **0 055 110**
A2

# (12) EUROPEAN PATENT APPLICATION

(21) Application number: **81305989.6**

(22) Date of filing: **21.12.81**

(51) Int. Cl.³: **G 11 C 11/34, H 01 L 27/06, H 01 L 29/80**

(30) Priority: **22.12.80 US 219023**
**26.01.81 US 228413**
**18.05.81 US 264888**
**02.06.81 US 269201**
**02.06.81 US 269926**
**13.10.81 US 311101**

(43) Date of publication of application: **30.06.82**
**Bulletin 82/26**

(84) Designated Contracting States: **DE FR GB IT**

(71) Applicant: **TEXAS INSTRUMENTS INCORPORATED, 13500 North Central Expressway, Dallas Texas 75265 (US)**

(72) Inventor: **Hynecek, Jaroslav, 608 Tiffany Trail, Richardson Texas 75081 (US)**
Inventor: **Bate, Robert T., 3106 Kristin Court, Garland Texas (US)**
Inventor: **Chapman, Richard A., 7240 Briar Cove Drive, Dallas Texas (US)**
Inventor: **Coleman, Donald J., Jr., 130 Sunset Drive, Plano Texas (US)**

(74) Representative: **Abbott, David John et al, Abel & Imray Northumberland House 303-306 High Holborn, London, WC1V 7LH (GB)**

(54) **Nonvolatile high density JFET RAM cell.**

(57) A dynamic memory storage cell having a single vertical junction field-effect transistor (JFET) for addressing stored binary data. A diffused region surrounding an elongated island forms the gats of the JFET, and a polysilicon region overlying the island and separated therefrom by a thin insulating layer forms the storage capacitor. Data is stored by the presence or absence of trapped charge on a multi-dielectric storage capacitor overlying the vertical JFET. The diffused gates of a plurality of JFETs form word lines which are spaced apart from parallel, transverse conductive bit sense lines. To program the nonvolatile capacitance, the address lines (word line and bit line) are biased so that a charge is given to the nonvolatile multidielectric stack between the MIS gate and the JFET source of the cell. Only positive voltages are used for programming and erasing of data in the cell. Isolation transistors prevent disturbance of half-selected cells.

## BACKGROUND AND SUMMARY OF THE INVENTION

This invention relates generally to data storage systems and more particularly to a transistor nonvolatile data storage cell.

Data information storage systems utilizing junction field-effect transistors (JFET) circuits as addressing elements have become increasingly popular due to the inherent advantages of the JFET structure. For example, such structures are generally less expensive to manufacture and may be produced with higher packing density than equivalent circuits utilizing bipolar transistors. JFET circuits have been advantageously utilized in a random access memory (RAM) as disclosed, for example, in U.S. Patent No. 4,126,900 to Koomen et al. entitled "Random Access Junction Field-Effect Floating Gate Transistor Memory." While the JFET structure enables relatively high packing density, there is continuing emphasis upon further reducing the area on the semiconductor slice required for each storage cell and also for increasing the yield of devices in a circuit. One factor that reduces the yield is related to the number of gates required to produce a given function, since the metal or conductive region on the thin insulator tends to short to the semiconductor material underneath. It may readily be seen that by reducing the number of gates required for a specific function, the yield may be improved.

An example of a MOS type storage cell that utilizes a single active device is described in U.S. Patent No. 3,852,800 entitled "One Transistor Dynamic Memory Cell," by Ohwada et al. While such a dynamic RAM cell, i.e., one that requires the stored information to be refreshed every cycle, significantly reduces the surface area used on the semiconductor chip, still smaller memory cells are desirable. One such device that offers high density and high speed of operation is a vertical JFET structure as described, for example, in U.S. Patent No. 4,142,111 to McElroy. This device uses a vertical P-channel JFET and a MOS transistor to form a static memory cell. Another device utilizing a vertical JFET-type structure is disclosed in a paper by J. Nishizawa et al. entitled "High Speed and High Density Static Induction Transistor Memory," published in the IEEE Journal of Solid-State Circuits, Vol. SC-13, No. 5, pp. 622-634, October 1978. This device utilizes a highly doped diffused source in a vertical P-channel structure.

Nonvolatile memory cells have the advantage of not requiring refresh operations every cycle as needed in dynamic memories. Typical nonvolatile memory cells, specifically those using metal-nitride-oxide-semiconductor (MNOS) storage structures, are disclosed in U.S. Patent Nos. 4,017,888 to Christie et al. and 4,112,507 to White et al. The cells described in these patents employ multiple planar MOS/MNOS devices and therefore occupy significantly larger areas than dynamic RAM cells laid out using equivalent design rules. To achieve a nonvolatile RAM which can supplant a dynamic RAM in most applications the cell size must be reduced to that of a dynamic RAM cell and the MNOS structure must be replaced by a low voltage, fast write, high endurance structure. To achieve a smaller cell size and high speed operation a vertical JFET such as that described in U.S. Patent No. 4,142,111 to McElroy, may be employed. This device uses a vertical P-channel JFET and a MOS transistor to form a static memory cell. However, fast write NVRAM devices heretofore known in the art have often exhibited undesirable read-disturb and crosstalk effects. That is, the adverse effects on nonaddressed cells caused, inter alia, by the large voltage drop across the storage structure of the addressed cell.

It is a principal object of this invention to provide a nonvolatile memory storage cell using a single JFET transistor to address the storage element. Another object is to provide a nonvolatile random access memory cell requiring a minimum of surface area on a semiconductor chip.

One aspect of the present invention is embodied in a nonvolatile memory cell which has a vertical JFET as the addressing element and, for example, a dual dielectric or multi-dielectric MNOS structure as the charge storage element. The substrate forms the drain of the JFET and a diffusion region having the same conductivity type as the substrate forms the source. The storage element overlaps and is separated from the source region by a thin gate oxide. An elongated diffused region of opposite conductivity type forms the gate of the JFET and also a word line of a memory matrix formed of a plurality of the cells. A thick oxide layer overlies the diffused word line and surrounds the storage element, and a conductive bit sense line formed, for example, of aluminum is oriented transverse to the word line and contacts the storage element. A polysilicon region recessed in the thick oxide layer may be provided as an electrode disposed between the storage element and the bit sense line.

Information is stored in a cell as a charge on the storage element, a "1" or a "0" state corresponding to the presence or absence of a charge.

In the fabrication of a cell of this type, several problems are encountered. The first problem is that the nonvolatile elements of the cell may suffer degradation of their memory properties. This is due mainly to processes that are performed on the cell to complete it after the nonvolatile elements are in place. Another problem is that of process compatibility between the fabrication of the RAM cells and the MOSFET interface and logic circuits which are built on the same chip.

The present invention is further directed to a method of fabrication of a nonvolatile (NVJRAM) cell which would have the nonvolatile element placed in the device late in process to avoid deleterious effects due to temperature cycles. Also, the method would accommodate the fabrication of logic circuits on the periphery of a chip to interface the RAM with other elements. The present invention, therefore, has an object of providing a method for fabrication of a nonvolatile RAM cell without damage to the memory element. Another object is to provide a method for fabrication of the nonvolatile RAM array that will allow interface logic circuits to be constructed on the same chip at the same time.

In one aspect of the invention, standard semiconductor fabrication process steps, well known in the art, are employed in a novel sequence to avoid damage or degradation of characteristics on any part of a finished nonvolatile JRAM array. Another aspect of the invention is the concurrent fabrication of the interface and logic circuits in MOSFET technology on the chip. A semiconductor substrate is patterned to form channels of one conductivity type, separated by channel "stops", or areas of the opposite conductivity type. Vertical JFET's are constructed on the channels, or word lines, and a layer of insulating material placed over the devices. A multi-dielectric stack having nonvolatile characteristics is formed directly over the source of the JFET in each cell, and a metal interconnection is made to the stack to serve as a bit line. A metal connection is also made to the channels in the substrate as a word addressing means. MOSFET devices are constructed on the same chip at the same time, by appropriate masking at each process step, thereby allowing only the necessary processes to affect that area of the chip on which the MOSFET devices are located.

The nonvolatile state of the memory insulator is read by (1) attempting to reverse bias the JFET source immediately beneath the MIS gate by applying an appropriate voltage to the MIS gate before and during closing of the JFET channel and then, (2) determining whether a reverse bias was obtained by floating the MIS gate and observing its voltage change when the JFET channel is reopened. The reverse biased JFET source can be discharged by the flow of current to the source from the JFET gate, the semiconductor substrate, the semiconductor surface, or the depletion layers separating these regions. These currents can be larger in high capacitance cells such as cells with MNOS capacitors due to edge effects associated with large electric fields and fabrication process induced defects.

If the reverse bias is discharged before the volatile state can be sensed, then the nonvolatile state of the insulator cannot be read. In the preferred embodiment, the present invention overcomes this difficulty by sensing the voltage feedthrough from word line to bit line which will depend on the absence or presence of an inversion layer underneath the memory insulator depending on the programmed state of the memory insulator. Since the inversion layer will be present or absent at equilibrium, there is no need to preset a nonequilibrium reverse bias and there is no sensitivity to dark currents. The other major improvement is that since a reverse bias does not have to be preset, no voltage pulse has to be applied to the bit line, which would normally have a small disturbing effect on the nonvolatile state of the memory insulator.

The present invention is also an improvement over MNOS DRAM cells as related in an article by R. Kondo, "DYNAMIC INJECTION NMOS MEMORY DEVICES", Japanese Journal of Applied Physics, Vol. 19, Supplement 19-1, p. 231-237, 1980, where the larger dark currents associated with NMOS edge effects and the nonequilibrium voltage states caused the same deleterious effects described above for the NVJRAM cells with the read mechanism of Patent Application No. 288,413.

Crosspoint nonvolatile capacitor cells placed at the intersection of orthogonal bit or word lines but without nonvolatile JRAM's have been investigated by J. I. Raffel and J. A. Yasaitis, "PROGRAMMABLE READ-ONLY MEMORIES", 1977 International Solid States Circuits Conference, p. 190-193 and 251, 1977, using a voltage ramp on the word line and sensing the capacitive feedthrough to the bit line. The present invention utilizes a more sensitive detection scheme in which a voltage step or pulse rather than a ramp is applied to the word line and a state-of-the-art DRAM sense latch is used to sense the small voltage feedthrough and then latch to a voltage such as zero volts in one state and +5 volts in the other state, depending on the written state of the memory insulator. In the present invention, the effect of nonselected cells on sensitivity is removed by reverse biasing all nonselected cell word lines sufficiently to pull out an inversion layer which may have been previously programmed in some cells.

In the past, MNOS capacitors have been used with a static RAM cell as related by S. Saito et al, "N-CHANNEL HIGH SPEED NONVOLATILE STATIC RAM UTILIZING MNOS CAPACITORS", Japan Journal of Applied Physics, Vol. 19, Supplement 19-1, pages 225-229, 1980, to provide nonvolatile information storage backup in the case of loss or electrical power. In this previous cell, one NMOS capacitor is placed on each of the two sides of the static latch. In the present invention, the nonvolatile capacitors are NVJRAM cells with many of these NVJRAM cells being placed on one bit line feeding each of the two inputs to the static latch which now becomes a DRAM-like sense latch. However, furthermore, the present invention is a high density nonvolatile RAM rather than a static RAM with nonvolatile backup.

Therefore, the present invention is in effect crosspoint capacitor memory array in which the small programming crosstalk effects inherent in the device of Raffel and Yasaitis have been diminished by the vertical JFET and in which a more sensitive capacitor read mechanism using voltage steps or pulses and the sense latch circuits have bee utilized. The read disturb effects inherent in Raffel and Yasaitis have been overcome by using a capacitance sense mechanism rather than preparing a nonequilibrium state. The low packing density of the static RAM cell of Saito has been converted into a high packing density DRAM-type cell and the information is normally stored in the memory insulator rather than using it only as a nonvolatile backup.

An object of this invention is to provide a nonvolatile random access memory cell for which the operation of reading the nonvolatile state of the cell has an improved (lower) disturbing effect on the nonvolatile state being read, with this improvement being obtained by reducing the reading voltage applied to the cell. Another object is to provide a read mechanism which does not utilize a nonequilibrium read mechanism which is strongly sensitive to dark currents, such as would be the case if a standard DRAM volatile write and read had been used. Another object is to provide a high sensitivity read operation for programmable capacitors which is compatible with the use of sense latches and has a sensitivity which is not affected by the pattern of data programmed at bits along one sense line. Yet another object is to provide a high packing density of programmable capacitors with as few components per cell as possible, having minimum read disturb and pattern sensitivity.

In one aspect of the present invention, there is provided a nonvolatile memory cell having a single vertical JFET as the addressing element for the cell. In a preferred embodiment, ion-implanting of n-type impurities in a p-type substrate creates a channel with islands of the p-type substrate surface appearing at spaced intervals. The channel serves as a JFET gate for each device, and also, as an address (word) line in a matrix of these memory cells. In one embodiment, the channel also is one electrode of the programmable capacitor of the cell. An insulating layer of, for example, silicon oxide covers the P-type source region and layers of dielectric material such as silicon dioxide, silicon nitride, and titanium oxide, covered by a conducting electrode, form the nonvolatile MIS gate and other electrode of the capacitor. A conductive strip of material, for example, aluminum is formed over the nonvolatile MIS gate and, in one embodiment, provides a bit line for addressing and sensing of the cell.

In another aspect, the cell stores data by introducing biases on the word and address lines to alter the charge stored in the nonvolatile insulator of the device, which in turn alters the capacitance between the MIS gate and the JFET gate, and thereby the capacitance between word and bit lines.

This alteration of device inter-electrode capacitance is readily sensed by a step or pulse on the word line voltage while reading the bit line. In one embodiment, the MIS gates are attached to the bit lines and the JFET gates are attached to the word lines. In another embodiment, the JFET gates are attached to the bit lines and the MIS gates are attached to the word lines. The cell is read by setting the bit line to a fixed potential, then floating it. The word line not floated has a positive or negative voltage step or pulse impressed upon it. The difference in the signal coupled from word to bit lines is easily determined by an output MOSFET device or by a sense latch, and data readout thereby accomplished.

In the standard nonvolatile cell, voltages of both positive and negative polarity are required to program and erase the memory element. The use of both polarities of voltage on a chip requires CMOS technology to implement the full devices of the array. In order to avoid the requirement for the more expensive and complicated CMOS, one alternative is to use a cell having an operating voltage of only one polarity for both programming the erasing. The use of a cell such as this would eliminate both the need for two polarities of operating voltage, and two types of semiconductor technology on the same chip. It is an object of this invention to provide a nonvolatile memory cell using low voltages and having fast programming times for both write and erase states, using the same polarity of pulse voltage for both operations. It is also an object of the invention to provide a cell which is implemented in a technology that will enable peripheral devices for array cells to be built on the same substrate.

A nonvolatile memory cell using low voltages and having fast programming times can only be obtained using highly efficient programming mechanisms. Unipolar voltage operation for MNOS and dual dielectric MOSFETS has been obtained in the past using avalanche-tunnel injection as shown by Y. Uchida et al in "A New Nonvolatile Read-Write Random Access Memory Operation by Means of Avalanche-Tunnel Injection in MNOS Transistor", Journal of Japan Society of Applied Physics, Volume 42, Page 151, 1973, and "A 1024 Bit-MNOS Ram Using Avalanche-Tunnel Injection", IEEE Journal of Solid State Circuits, Volume SC-10, Page 288, 1975. Avalanche punch-through erase is shown by D. Kahng, J.R. Brews, and W. J. Sundburg, "Avalanche Punch-Through Erase Mode in Dual-Dielectric Charge-Storage (DDC) Cells", IEEE Transactions on Electron Devices, Volume ED-24, Page 531, 1977. In these devices, the write operation is obtained by placing a large voltage on the gate with the substrate, source, and drain all grounded, thus pulling the charge of a polarity opposite to the gate voltage into the insulator; to erase a voltage pulse of the same polarity as used in the write operation is placed on the source and drain simultaneously with the gate and substrate grounded. During erasure either the charge in the insulator is forced into the channel or the majority carriers in the channel (charge of sign opposite to that of the charge previously written in the insulator) are forced in through the insulator. Unfortunately, in a MOSFET, the majority carriers are not entirely confined to to the channel and can leak away to the substrate through the two sides of the MOSFET channel adjacent to the channel stop which is underneath the field oxide as shown in Kahng and Brews. The escape of carriers to the channel stop decreases the efficiency of the erase mechanism since the channel voltage will not rise to as large a value as would be the case if the channel were completely isolated. Unlike the MOSFET structure, the structure of the present invention completely seals off the channel under punch-through conditions.

In addition to the erasure mechanism described above in which the thermalized, trapped majority carriers tunnel to the memory insulator, hot carriers from diode breakdown can overcome the silicon oxide potential barrier and enter the insulator as shown in both the Uchida articles and also in H. Hara, et al, "Avalanche-Injection MOS Read-Only Memory", Proceedings of the Third Conference on Solid State Devices, Tokyo 1971, Supplement to Oyo Buturi, Volume 41, Page 163, 1972. This process is more efficient for P-channel MOSFET's compared to N channel MOSFET's because the barrier for electrons (majority carriers in the P channel layer) is smaller than for holes as shown by Hara. Since the hot majority carriers thermalize as they leave the diode junction region underneath the MIS gate, the hot carrier erasure process is more effective near the junction resulting in a non-uniform, time dependent erasure of the insulator charge in the MNOS or multi-dielectric structures.

In an MOSFET where many of the majority carriers created by the breakdown mechanism escape to the channel stop, the erasure mechanism is not highly efficient and the breakdown current must flow for a longer time to obtain erasure; the increased duration of breakdown current flow increases the contribution of hot carriers to the erasure process. In the inventive unipolar voltage NVJRAM, the hot majority carriers still contribute to the erasure process, but the erasure process due to the thermalized channel carriers is increased in efficiency, resulting in an erasure which is more uniform over the channel surface. One aspect of the present invention is embodied in a nonvolatile memory cell having a single vertical JFET as the addressing element and, for example, a dual dielectric or a multi-dielectric NMOS structure as the charge storage element. The substrate forms the drain of the JFET and a diffusion region having the same conductivity type as the substrate forms the source. The nonvolatile storage element overlaps and is separated from a source region by a thin gate.

In another embodiment, the charge storage element is a silicon floating gate separated from the vertical JFET source by a thin insulator and separated from a control gate (above the floating gate) by another insulator, with the rest of the NVJRAM structure being the same as in the preferred embodiment. In yet another embodiment, the dual dielectric capacitor contains a dopant or small conducting islands at the interface of the two dielectrics with the nonvolatile charge stored on the dopant or conducting islands. An individual cell according to the present invention requires an area as small as 0.25 mil squared, providing an extremely high density nonvolatile random access memory.

The operation of the NVJRAM array as described above results in small voltage drops occurring across the nonvolatile insulators of the cells not selected to be written or erased. One pulse application of these small voltages is not sufficient to change the nonvolatile state of the cell and the write or erase operation is inhibited. However, each non-selected cell may experience many inhibited write or erase operations before that cell is itself selected to be written or erased. The small voltage which occurs repeatedly across the nonvolatile insulators of the non-selected cells can cause a disturbance of the written or erased state of th e cell. This problem can be severe using an insulator designed for fast write/erase at low write/erase voltages. Furthermore, even the application of a small voltage to interrogate or read the state of a cell selected for reading can disturb the programmed state of cells not selected for reading if the reading operation is repeated many times before the cells not selected for reading is selected for reprogramming. These problems arise because of the use of only two types of cell address lines and the limitations of the degree of isolation provided to the nonvolatile insulator by the vertically oriented JFET when utilized with a fast write/erase nonvolatile insulator structure.

The use of only two types of address lines and a vertical JFET underneath the memory insulator permits the construction of a very high density memory array. The use of this design to obtain high density in the memory array results in the need for more complicated peripheral circuitry: for instance, to program, erase, or refresh the programmed state, voltages must be selected and addressed to both the horizontal and the vertical address circuits.

The preferred embodiment of the invention uses a total of three types of address lines and adds either one or two MOSFETs per memory cell for isolation. The additional type of address line is used to connect the MOSFET gates and in the preferred embodiment this line is used as the word line in this design. The JFET gates of the NVJRAM elements can be connected to a column line (column line A), which is parallel to a second column line (column line B) which is connected to the MIS gates of the NVJRAM elements. Either column line A or column line B can serve as the bit line. In one embodiment, one MOSFET isolates the MIS gate of a cell from its column line B and the other MOSFET isolates the JFET gate of a cell from its column line A. In this embodiment, the MOSFET on the MIS GAte side of the cell must include a via to connect the NVJRAM MIS gate to the MOSFET source; the MOSFET on the JFET gate side of the cell has its MOSFET source directly tied to the JFET gate without a via and this portion of this cell requires only the addition of the MOSFET gate or transfer gate to the NVJRAM construction. This embodiment with two MOSFETs provides very good isolation of nonselected cells from the disturbing effects of read, write and erase operations on other cells selected for these operations.

In two other embodiments, only one MOSFET is added to each cell: (1) an embodiment using a MOSFET to separate the MIS gate of the NVJRAM element from the column line B with the JFET gate of the NVJRAM element connected directly to the column line A and (2) another embodiment in which a MOSFET is used to separate the JFET gate of the NVJRAM element from column line A with the MIS gate of the NVJRAM cell connected directly to the column line B. In the first case, the MOSFET provides excellent isolation for nonselected NVJRAM elements from write pulses on column line B; this design also improves the isolation of non-selected elements from erase pulses on a column line A by floating the MIS gate of a nonselected NVJRAM so that most of the erase voltage drops across the MOSFET. In the second case, the MOSFET provides excellent isolation for nonselected NVJRAM elements from erase pulses on column line A; this design can also improve the isolation of the nonselected elements from write pulses if the JFET gate of the nonselected NVJRAM element is preset and floated at a positive voltage of sufficient amplitude to close the JFET channel and to float the JFET source prior to the application of the write pulse down column B to the selected memory cell. Of the three embodiments described above, the embodiment with only one MOSFET or transfer gate on the JFET gate side will lead to the smallest memory cell size because only one gate must be added and no additional via is required.

The three types of address lines and MOSFETs can also be used in other ways. For instance, the NVJRAM array

14

0055110

organization can be maintained with JFET gate atatched to the word line and the MIS Gate attached to the bit line; the address line attached to the MOSFET gates can be run prarallel to the bit line and orthogonal to the word line. In this case, the addressing of the write/erase voltages still involves the high voltage on both horizontal and vertical address lines but improved isolation is obtained against the disturbing effects on nonselected cells due to write, erase, or read operations on selected cells.

## BRIEF DESCRIPTION OF THE DRAWINGS

The novel features believed characteristic of the invention are set forth in the appended claims. The invention itself, however, as well as further objects and advantages thereof will be best understood by reference to the following detailed description when read in conjunction with the accompanying drawings, wherein;

FIGURE 1 is a schematic diagram of a data storage cell according to a first embodiment of the present invention;

FIGURE 2 is a partial, vertical cross-sectional view of the storage cell of FIG. 1;

FIGURE 3 is a plan view of the cell of FIGURE 2;

FIGURE 4 is a cross-sectional view of the storage element of the cell of FIGURE 1;

FIGURE 5 is a perspective view, partially cut away, showing the geometry of a cell made by the present invention;

FIGURE 6A-6E are cross-sectional drawings of the structure at various stages of completion of the disclosed method of fabrication;

FIGURES 7A-7B show the equivalent circuits for the nonvolatile capacitor NVJRAM in two different programmed states for a p-channel JFET;

FIGURE 8 shows the construction of the nonvolatile capacitor NVJRAM memory array with the MIS gate attached to the bit lines with sense latches;

FIGURE 9 shows the waveforms for operation of the nonvolatile capacitor NVJRAM memory using sense latches.

FIGURE 10 shows operating waveforms of a unipolar voltage NVJRAM memory;

FIGURE 11 shows the voltages using unipolar voltage JRAM with sense latches;

FIGURE 12 is a schematic diagram of two fully isolated NVJRAM cells of the present invention;

FIGURE 13 is a schematic diagram of a preferred embodiment of the present invention;

FIGURE 14 is a schematic diagram of a second preferred embodiment of the present invention, and

FIGURE 15 is a schematic diagram of an alternative method of addressing an isolated cell when physically implemented.

## DETAILED DESCRIPTION OF THE INVENTION

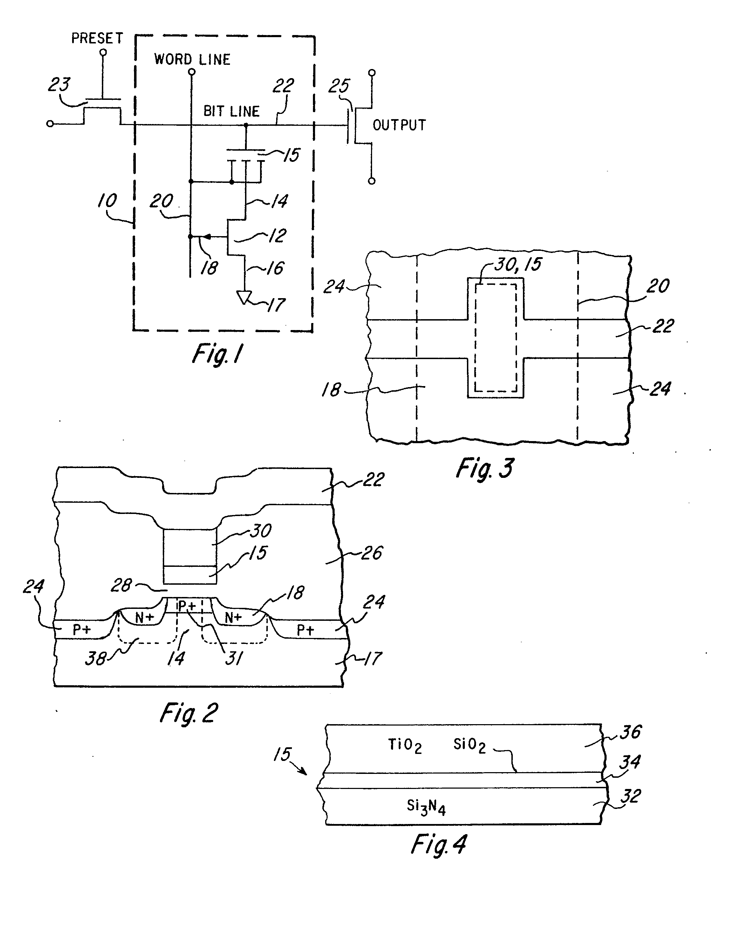

Referring now to the drawings, there is shown in FIGURE 1 a schematic diagram of a single, nonvolatile, junction field-effect transistor random access memory (JRAM) cell 10 according to the first embodiment of the present invention. Memory cell 10 is formed of a vertical JFET 12 having a source 14 capacitively coupled to a storage element 15, a drain 16 coupled to the substrate 17, and a gate 18 which is part of a word line 20. Storage element 15 is also coupled to a bit sense line 22. A typical RAM is formed of a matrix of cells 10 coupled to a plurality of rows of sense lines 22 and columns of word lines 20. A specific cell is addressed by simultaneous impulses on the corresponding bit sense and word lines. A preset transistor 23 and an output transistor 25 are provided for applying write and erase potentials to bit sense line 22 and for sensing the output of storage element 15 during the read operation.

Referring to FIGURES 2 and 3, the structure of cell 10 may be better understood. A portion of a semiconductor substrate, e.g., silicon, is shown generally at 17. The substrate may be either N-type or P-type depending upon design considerations. For purposes of illustration, it will be assumed that a P-type substrate is utilized.

Word line 20 is an elongated N+ region which also forms the gates 18 for all of the JFETs in a column. A P+ region on either side of the gate region 18 forms a channel stop 24 to isolate the cell 10. A relatively thick insulating layer 26 of, for example, silicon dioxide overlying the gate 18 and channel stop 24 regions has an elongated, thin gate oxide region 28 overlying the source 14 of JFET 12. Storage element 15 is formed of a multi-dielectric structure overlying gate oxide 28 and surrounded by oxide layer 26. Overlying the storage element 15 is a polysilicon region 30 that forms a contact electrode that is coupled to a conductive strip of, for example, aluminum which forms bit sense line 22.

The P-type silicon substrate has an inpurity concentration on the order of (for example) 1013 atoms/cm$^3$ and a thickness of perhaps 20 mils. Channel stops 24 have a P+ doping of about 1015 atoms/cm3, and gate region 18 and word line 20 are doped N+ with a concentration of about 1015 dopant atoms/cm3. Insulating oxide layer 26 has a thickness of about 10,000 Angstroms overlying channel stops 24 and a thickness of about 3,000 Angstroms overlying gate region 18 adjacent to the storage element 15. Gate oxide 28 has a thickness of about 25 Angstroms, and bit sense line 22 is formed, for example, by the evaporative deposition of aluminum to a thickness of about 12,000 Angstroms. A more heavily doped P+ region 31 may be included in the source region 14 if it is desired to alter the voltage threshold characteristics of JFET 12.

Storage element 15 is a multi-dielectric structure, of which an example is shown in FIGURE 4. In one embodiment structure 15 is formed of a silicon nitride layer 32 having a thickness of 100-300 Angstroms, a silicon dioxide layer 34 having a thickness of about 40 Angstroms, and a titanium dioxide (rutile) layer 36 having a thickness of about 1,100 Angstroms. Fabrication of the above structures is described in U.S. Patent Applications Serial Nos. 963,855 and 968,545, filed on November 27 and December 11, 1978, respectively, and incorporated herein by reference. These charge storage structures are described by way of example only and are not intended to be a limitation, as other structures will be apparent to those skilled in the art. For example, a tunnel-injection floating gate structure may also be employed.

In operation, according to this first embodiment of the invention, in the storage mode cell 10 is not addressed and a positive potential of about +10 volts is applied to gate 18. This turns off JFET 12 and forms a depletion region, indicated by the dashed lines 38 in FIGURE 2, which spreads under the gate and creates a pinch-off condition. Information is written into the JRAM cell in the following manner. In a first state "1" a positive charge is programmed into storage element 15 by applying a negative potential of about -10 volts to bit sense line 22 and a positive voltage of about +5 volts to word line 20. The absence of this charge indicates a second state "0". Following a write operation the cell is returned to the nonselected storage state as described above wherein the cell is again in a pinch-off condition. In the read operation JFET 12 is turned on by applying +5 volts to word line 20 and sensing the voltage on bit sense line 22, which in turn is proportional to the charge stored on element 15. The information in the JRAM is erased by holding the word line 20 at zero potential and applying the +10 volts to bit sense line 22. The read operation as described above is preceded by a refresh or reset operation wherein the JFET is turned on by applying +5 volts on both word line 20 and bit sense line 22 to deplete the area under gate 18. The refresh operation is required to charge storage element 15 to a nonequilibrium state in order to provide a signal when the cell is addressed. All unaddressed cells in a JRAM matrix will have either their associated JFET turned off or their associated bit sense line voltage equal to zero, resulting in only a small voltage drop across their multi-dielectric storage elements 15. This in turn minimizes the read-disturb and crosstalk effects without a corresponding increase in either the write voltage or the write time.

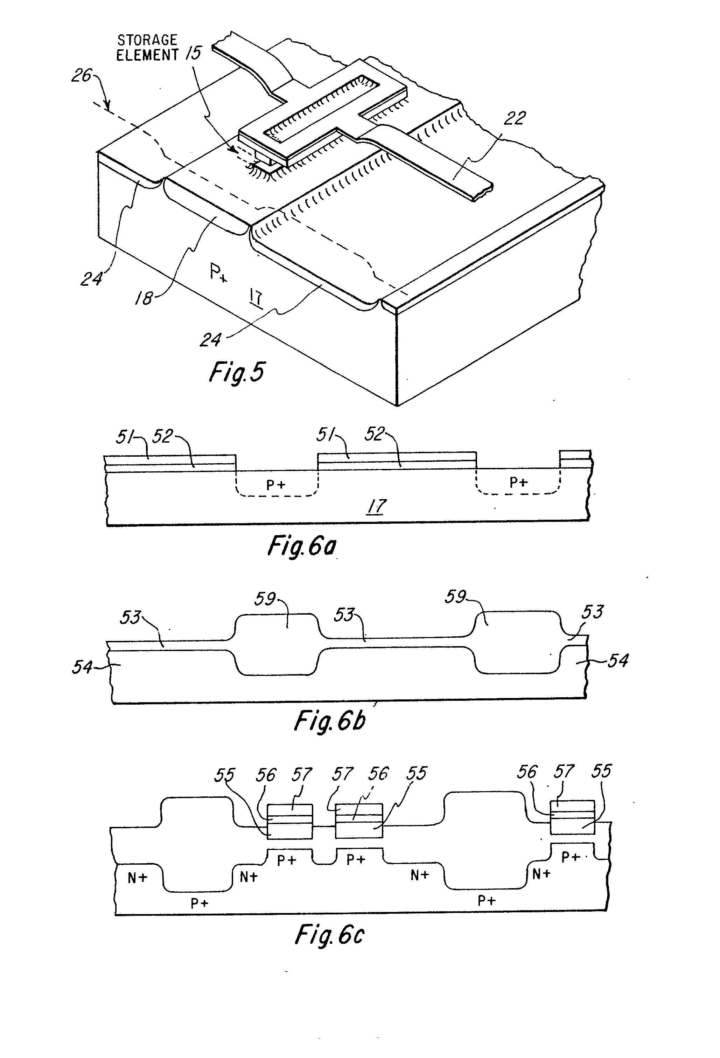

To fabricate the above embodiment of the present invention, semiconductor substrate 17 is made of, for example, p-type silicon having a low resistivity, such as 0.2 ohm-cm, with an epitaxial layer of silicon approximately .4 to .5 mil deep having a sheet resistance of from 20-30 ohm-cm when the memory element electrode 30 has a minimum width of 0.2-0.25 mils. Smaller minimum widths require epitaxial resistivities less than 20-30 ohm-cm. On this surface is grown a layer of silicon oxide 52 about 1000 A deep, using a standard thermal oxidation furnace. Next, a layer of approximately 1400 A of silicon nitride 51 is deposited over

the SiO$_2$. The device is then coated with photo resist, and areas to be etched are masked, then the slice exposed. The mask is removed, then the photoresist developed, and the non-exposed photo-resist stripped away. Next, a plasma etch removes the areas of exposed nitride. Then, a Bell-2 etch removes the exposed oxide. After a rinse to remove the photo resist, Boron is implanted in the exposed substrate areas in a dosage of $4 \times 10^{13}$/cm$^2$ at 40 KeV to form P+ channel stops 24. At this point, a cross section of the device is as shown in Figure 6A.

Next, the slice is placed in a thermal oxidation furnace at 1000 degrees C to grow an oxide layer 59 over the exposed substrate to a thickness of 9000-10,000 A. Now, etch away the SiN3 and SiO2. a layer of SiO2 53 is grown on the exposed substrate to a depth of 800 A, and a mask step covers the thick oxide area. The substrate covered only by the 800 A SiO$_2$ is now subjected to an ion implantation step which implants Boron into the substrate at a dosage of 2 to 5 x $10^{12}$/cm$^2$ at 40 KeV to form a thin p+ region 54. After the masking is removed, the structure is as shown in Figure 6B.

Now, 5000 A of polysilicon 55 is deposited on the thin oxide layer area using a hot-wall reactor at 620 degrees C. Then, phosphorous is deposited and diffused at a dosage of to create N-type conductivity in the polysilicon. Next, a layer of SiO$_2$ approximately 200 A thick 56, and a layer of insulator such as silicon nitride approximately 1400 A thick 57, respectively, are grown over the polysilicon. The silicon nitride, or other insulator, must not be easily oxidized, but must be etched away later with an etchant that does not etch SiO2 rapidly. The remainder of this description will assume a silicon nitride insulator. A masking operation is performed, and the undesired areas of silicon nitride and polysilicon are etched away. With the photoresist still in place, phosphorous is ion-implanted in the exposed areas in dosage sufficient to overcome the thin P+ doping previously accomplished and cause the area to become N+ type. The photo resist is now removed, and a layer

of $SiO_2$ 60 grown over the N+ areas is a depth of about 3000 A. The device is then as shown in FIGURE 6C.

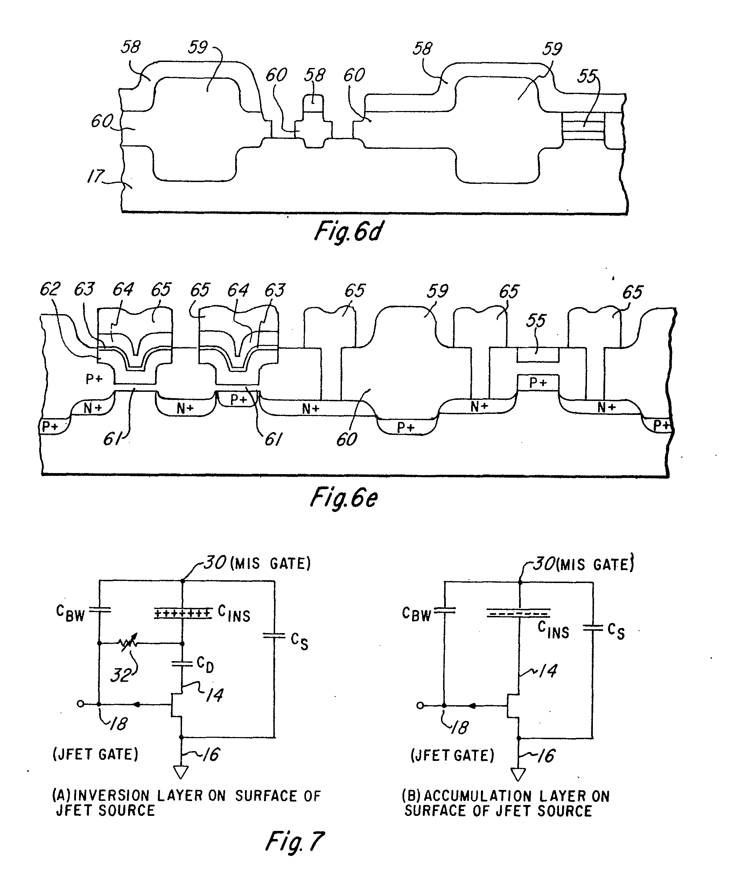

The next step is to coat the device with photoresist 58 mask to the appropriate areas, then develop the photoresist and strip away those areas not developed. An alternative step at this point is to etch away the silicon nitride layer over $SiO_2$ and polysilicon, then proceed with the photoresist. In either case, the nitride, oxide, and polysilicon areas are etched away, as well as the gate oxide on the surface of the substrate. Note that, as shown in FIGURE 6D, the nitride, oxide and polysilicon areas on the right side of the drawings are shown under photoresist. This is to illustrate the order of events for the MOSFET devices which are to be built as interface logic for the RAM cells. The structure is now as shown in FIGURE 6D.

The last series of steps puts in place the nonvolatile multi-dielectric stack. The placement of these steps at the end of the fabrication process avoids having the multi-dielectric stack subjected to temperature cycling, which would have an adverse affect on the nonvolatile characteristics of the cell.

The photoresist 58 is stripped away, and then a thin layer of $SiO2$ 61 approximately 20-40 A thick is grown on the exposed substrate. A layer of silicon nitride 62 is now deposited over the $SiO2$ to a thickness of. 75-500 A. In an alternative step, if the subsequent optional step of depositing titanium oxide ($TiO2$) on the stack is not used, the thickness of the silicon nitride should be at least 150 A, up to 500 A. After the silicon nitride is deposited, the top 50 A is thermally oxidized to convert it to $SiO_2$ 63. Next the titanium is deposited. Then photoresist is applied and patterned so that nonvolatile areas will be covered after exposure and development, and stripping of excess photoresist. The undesired titanium is edtched away, and the photoresist is removed from the nonvolatile areas. The titanium is oxidized to convert it to $TiO_2$ 64. Now the oxide is etched off to expose the polysilicon in the MOSFET area.

Photoresist is applied, and patterned to remove excess photoresist, then oxide is patterned in selected areas to form vias to the substrate. Photoresist is then removed, and a short clean-up etch is done to insure no oxide remains on the polysilicon or in the vias. Then aluminum or other metal 65 is deposited for interconnection. Photoresist is applied and patterned, followed by and the etching away of undesired metal. The structure is now completed except for connections to the chip header, and is as shown in FIGURE 6E.

According to a first mode of operation of the invention, the cell is programmed in the following manner. Programming of the cell requires the multidielectric structure 15 above the source region 31 to have a charge imported to it through the thin oxide 28, and the polarity of this charge will determine whether an inversion layer is present at the surface of the source region. To program a positive charge into the insulator, a negative voltage, such as -20 volts, is applied to the bit sense line and MIS gate. The required voltage is dependent upon the thickness of the insulating layer 28 and the thickness of the multidielectric structure 15 being charged. While the negative voltage is applied to the bit sense line, the word line and JFET gate are held at a zero potential. This bias causes the insulator layer to be positively charged. After the programming voltage is removed, the positive charge in the insulator attracts electrons from the JFET gate region and causes an inversion layer to form over the surface of the JFET source region. Cells on the bit line which were not to be programmed when the -20 volt pulse was applied had their word lines at say +5 volts in order to close their JFET channels and float their JFET sources which then became reversed bias through the effect of the -20 volt pulse, thereby resulting in insufficient voltage drop for programming across the memory insulator 15 and thin insulator 28.

To program a negative charge into the insulator, a positive voltage, such as +20 volts is applied to the bit line and MIS gate while the word line and JFET gate are held to a zero potential. The +20 volts on the MIS gate 30 temporarily pulls an inversion layer over the JFET source 18 and then pulls electrons into the insulator 15 from the inversion layer and/or pushes positive charge from the insulator into the inversion layer. When the +20 volt programming pulse is removed from the MIS gate 30, the negative charge in the memory insulator 15 repels the inversion layer and an accumulation of positive holes form over the JFET source 31. Those cells connected to the bit line which are not to be programmed have their word lines and JFET gates reversed biased to increase the potential of the inversion layer during the +20 volt pulse so that insufficient voltage for programming occurs across the memory insulator.

The reading or sensing of the nonvolatile state of the memory insulator 15 is described with reference to Figures 7A and 7B. When negative charge has been previously programmed into the memory insulator 15, the state shown in Figure 7B occurs (with an accumulation layer). The capacitance between bit line and word line is now $C_{bw}$, which is due to the capacitance from conductor 30 and bit line 22 to the JFET gate 18 through insulator 26. In those cases with overlap of JFET gate 18 and conductor 30, there will be additional capacitance through a small area of insulators 15 and 28 around the periphery of JFET source 31. The capacitance $C_{bw}$ is designed to be small. The very large capacitance $C_{ins}$ through thin memory insulator 15 and JFET gate 18 is A/C coupled to the substrate 17 through the JFET in this case. This model neglects the sidewall capacitance between the JFET source 31 and the JFET gate 18 in comparison with the other capacitances.

If positive charge has been previously programmed in to the memory insulator 15, the state shown in Figure 7A occurs (with an inversion layer). Now the inversion layer connects the bottom electrode of the memory capacitor to the JFET gate electrode through a variable but low channel resistance 32. The source 14 of the JFET is now separated from the inversion layer by a depletion layer capacitance $C_d$. The capacitance between the bit line and the word line is now ($C_{bw} + C_{ins}$) which can be much larger than $C_{bw}$ that by itself is the interelectrode capacitance for the programmed state of Figure 7B. It is important to note that the charge programmed into the memory insulator 15 does not change $C_{ins}$ but has its effect on programmed capacitance through the connection of $C_{bw}$ and $C_{ins}$ obtained by the inversion layer. In the circuit of Figure 1, only one cell is shown on the bit line. In a practical array, many cells are placed on one bit line, thus resulting in an extra stray capacitance $C_S$ (of Figure 7). In the read operation, a pulse or negative going voltage step is placed on the word line and the resulting voltage step is sensed on the floating bit line. In the case of an accumulation layer as in Figure 7B, the bit line voltage change $\Delta V_B$ $(-)$ is related to the change in the word line voltage step $\Delta v_w$ by:

$$\Delta V_B (-) = \frac{C_{Bw}}{C_{Bw} + C_{ins} + C_s} \Delta V_w$$

In the case of an inversion layer as in Figure 4a, the corresponding change is

$$\Delta V_B (+) = \frac{C_{Bw} + C_{ins}}{C_{Bw} + C_{ins} + C_s} \Delta V_w$$

and the difference between the states is

$$\Delta V_B (+) - \Delta V_B (-) = \frac{C_{ins}}{C_{Bw} + C_{ins} + C_s} \Delta V_w$$

The sensitivity of the read operation is increased by minimizing the stray capacitance $C_S$ which is mainly due to the other cells on the bit line. The stray capacitance $C_S$ is minimized by reverse biasing the JFET gates of all cells not being read on the bit line to a voltage sufficient to close the JFET channels and pull the inversion layers of these cells out from under the memory insulator. Figure 7 has been drawn for the embodiment having the MIS gates attached to the bit lines. In the alternative embodiment having the JFET gates attached to the bit line, the corresponding stray capacitance on the bit line includes the junction capacitance of the JFET gate 18. This junction capacitance is minimized dby reverse biasing the JFET gate 18 and by using a lightly doped substrate, for instance $5 \times 10^{14}$ atoms/cubic centimeter doping. The capacitance of the cells not to be read or minimized by proper selection of the bit and word line voltages for the cells selected for reading and those not selected for reading.

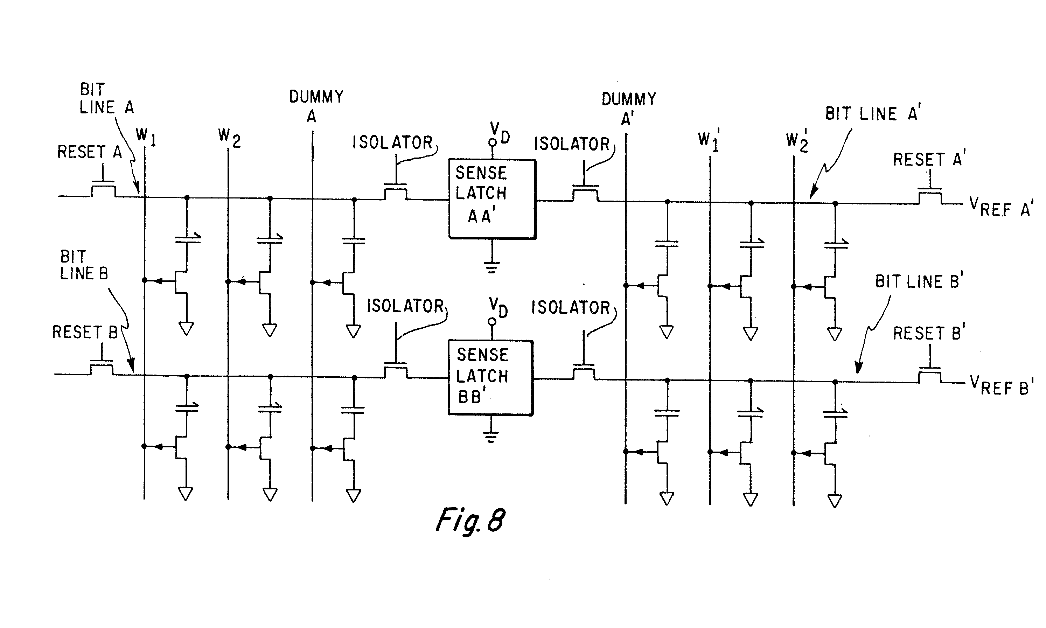

The practical memory array will use sens latches as shown in Figure 8, rather than output MOSFET's as shown in Figure 1. Any of several sense latch designs common to the art of dynamic RAM's can be utilized. Moreover, folded bit lines may also be used, as will be obvious to those skilled in the dynamic-RAM art. The memory shown in Figure 8 has two sense latches, each of which have two bit lines with each bit line having two nonvolatile capacitor NVJRAM elements oriented with MIS gates on the bit lines and with one dummy cell on each bit line. Although a JRAM without nonvolatile insulator is shown as the dummy cell, a capacitor with a fixed capacitance which is the average of that of the two program states of the NVJRAM elements could have been used. Furthermore, although only two sense latches are shown and only two NVJRAM cells per bit line are shown, it should be obvious that larger memories with many sense latches and many NVJRAM cells per bit line could be used.

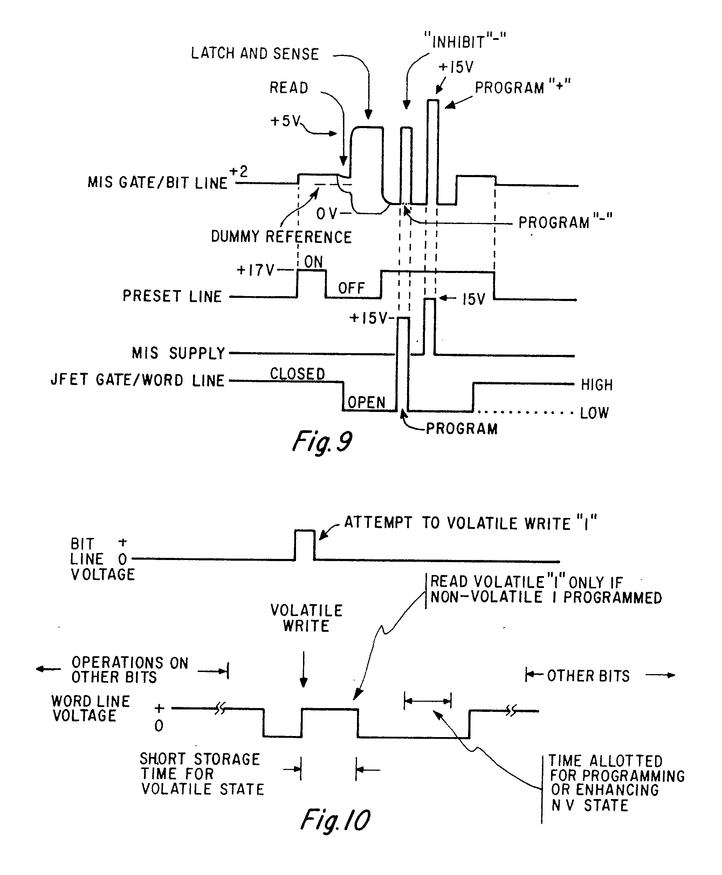

Figure 9 shows the waveforms for the operation of the nonvolatile capacitor NVJRAM memory array of Figure 8. Both Figure 8 and Figure 9 refere to the embodiment with the MIS gate attached to the bit line, but the construction and waveforms for the alternative embodiment with the JFET gate attached to the bit line is obvious to those skilled in the art. In the read operation for bit lines aa', the preset transistors a and a' are turned on and both bit lines are preset to a low voltage of say, +2 volts with the optional isolator MOSFET's on. The preset MOSFET's are then turned off to float the bit line, and the word line voltage is decreased for the cell to read on bit line a and at the same time the word line voltage for the dummy cell on opposing bit line a' is decreased by the same voltage step. If the cell is in a programmed state of large capacitance, the voltage of the bit line a will decrease more than that on the bit line a' with the dummy cell. If the cell is in a programmed state of small capacitance, then the voltage on the bit line a will decrease less than on the bit line a'. At this point in time, the bit lines a and a' will have a small voltage difference. If it is required that the sense latch voltage not be fed back to the memory cell, then the optional isolation MOSFET's can be turned off before the sense latch is activated. When the sense latch is activated, the bit line will go to low voltage (zero volts) if the cell was in a large capacitance state, and would go to a voltage of intermediate value (+5 volts) if the cell were in the low capacitance state.

The state of the sense latch can now be interrogated. This operation of the sense latch is common to the state-of-the-art DRAM and any of several types of construction could be used. If it is required to reinforce or refresh the program state just read using the sense latch voltage, then the MOSFET isolators can be turned on again (or never turned off), and the +5 volt sense latch voltage can be applied to the gate of the selected MIS gate. This voltage tends to reinforce the low capacitance state of the cell which caused the sense latch to go to this voltage. If the cell had been in the high capacitance state, this MIS gate will receive zero volts in this operation and the information on this sense latch must be sent via peripheral circuitry to the word lines to send the selected word line to +5 volts to reinforce the high capacitance state. To accomplish this operation without other disturbing effects, all unselected bit lines must be at an intermediate voltage or floating. If the voltage step on the JFET gate to initiate the read operation had been positive going rather than negative going, the above mentioned reinforcement of the program state would not have been possible. In the second embodiment where the JFET gates are attached to the bit lines and the read initiation voltage step is applied to the MIS gate, a positive-going step is applied to the MIS gate, a positive going read initiation step would be the proper sign of voltage to obtain proper reinforcement of the programmed state using the latch voltage.

The last portion of the cycle in Figure 9 shows the preset transistor turned on again for reprogramming of the cell. As is shown, a larger voltage is used for programming (15 volts, for example) than for reading or reinforcing the memory state of the cell. The cell may be programmed using positive or negative voltage on the bit line as in Patent Application No. 288,413 or all positive voltages on the bit line and word line as shown in Figure 9. Although the embodiments described in the figures utilize memory insulators, it should be recognized that the memory insulator could be replaced by a silicon floating gate which would be separated from the JFET source by an insulator layer and further separated from the MIS gate (which becomes the control gate) by another insulator layer. In these embodiments, the memory charge would be stored on the silicon floating gate which would in turn create an inversion or accumulation layer over the source. Likewise, the storage medium could be metal islands or interfacial doping with the insulator layer below and an insulator layer above separating the islands or dopant from the MIS gate. This cell and method of storage and reading provide significan advantages over the NVJRAMS currently known.

The method for reading the stored data has greater immunity to "read disturb" than standard JRAM's, as no positive pulse is required to prepare the empty "well" or in other words reverse bias the JFET source. Since the cells in an array are located at the intersection of word lines and bit lines, the array could be compared to a crosspoint capacitance nonvolatile memory. However, an array of cells of the present invention would be unlike the crosspoint capacitance nonvolatile memories, as it has a JFET device associated with each programmable capacitance. This permits larger signal output, and eliminates pattern sensitivity. (Pattern sensitivity is the dependence of the signal output magnitude of the addressed bit upon the data written on all the other bits in the line.)

The preferred mode of operation which uses positive voltages only, will now be described. Non-volatile information is stored in the cell by forcing charge into the non-volatile insulator stack 15. One charge state is written by placing a large voltage of, for instance, 15 volts by 100 nanoseconds on the bit sense line 22 while the substrate 17 and the gate 18 of the selected cell 1 are held at low voltage, for instance, 0 volts. Those cells on the bit sense line which are not selected for programming have their gate lines 18 held at an intermediate amplitude voltage, for instance, 5 volts which is sufficient to close the vertical JFET channel and to increase potential of the inversion layer which forms over the JFET source during programming. The intermediate voltage is chosen to be insufficient to cause perturbation of the memory state of the non selected cells. Writing or programming the above state can be termed writing a non-volatile "1" state. To erase or program the opposite state, a large voltage of, for instance, 15 volts for 100 nanoseconds of the same polarity as used in programming the one state is placed on a selected word line 24 with the selected cell 10 along the word line having a low voltage, for instance, 0 volts on its bit sense line 22. These voltages on the selected cell 10 result in closing the channel of the vertical JFET beneath the selected cell and in floating the JFET source which is then held at low voltage by the action of the high capacitance between source and bit sense line. Since the JFET source is held at low voltage while the JFET gate goes to high voltage, junction breakdown can occur between the source and gate of the JFET especially at the surface where the electric field between the bit sense line contact 30 and the JJET gate 18 act to increase the electric field in the depletion layer between the JFET gate and source. If breakdown occurs at voltage $V_{BK}$, then a voltage $(V_D-V_{BK})$ will appear on the JFET source when a voltage $V_D$ is applied to the JFET GATE. The voltage $V_{BK}$ is in part dependent on the doping concentration in the JFET source, but is also dependent on the voltage of the bit sense line and the insulator thicknesses 28 and 15 and the charge previously programmed into insulator 15, with much lower $V_{BK}$ occurring for the thinner insulators and lower bit line voltages. Those cells not selected for erasure along the word line have intermediate amplitude voltages, for instance, 5 volts applied to their bit sense lines. This intermediate voltage does not have to be high because of the large effect of the voltage on 22 and 30 on the breakdown voltage $V_{BK}$. This erasure mechanism results in the charge in the insulator after writing the non-volatile 1 state being pulsed out of the memory insulator 15 into the JFET source, or alternatively, majority carriers (of charge sign opposite to that previously written in the layer 15) are pushed into 15 to cancel the previously written charge or to over-compensate this charge and write a charge state of opposite sign. In any case, this latter programming mechanism will be termed erasure or writing the non-volatile "0" state. This mechanism has the advantage of being self-limiting since the breakdown voltage $V_{BK}$ will increase as the charge in the insulator 15 is changed during the erasure process, thus automatically shutting off the erasure process.

In the preferred embodiment, the structure of the unipolar voltage NVJRAM includes an overlap of the JFET gate 18 and the sense line contact 30. This overlap is needed in order that the voltage of the contact 30 can have a large effect on the breakdown voltage $V_{BK}$, which permits lower breakdown voltages $V_{BK}$ for the selected cells which have contact 30 at, for instance, 0 volts and higher $V_{BK}$ for the unselected cells which have contact 30 at, for instance, 5 volts. A consideration of this construction is that the above overlap must be small enough to result in small overlap capacitance between the contact 30 and JFET gate 18, since this overlap capacitance acts to lower the sense signal to be described next. In an alternate embodiment, the P-type carrier concentration of the JFET source 14 is increased to lower the breakdown voltage substantially using a thicker insulating 15 and 28. In another alternative embodiment, the larger P-type concentration is used and the insultor 28 thickness is increased only in the periphery of the JFET source above the N+P+ junction.

Although the information is stored in the memory insulator, the memory state must be sensed by the electrostatic action of the memory insulator on the surface of the JFET source. The charge state can be sensed dynamically by placing an intermediate amplitude voltage pulse of, for instance, 5 volts for 100 nanoseconds on the selected bit sense lines 22 and low voltage, for instance, 0 volts on the selected word line 24 with the unselected cells on the bit line having their word lines at an intermediate voltage sufficient to close their JFET channels, for instance, 5 volts. The bit line voltage of the selected cell is held at the intermediate voltage while the word line of the selected cell is increased to an intermediate voltage of, for instance, 5 volts sufficient to close its JFET channel. After the JFET channel of the selected cell is closed, the voltage on the selected bit line is lowered, for instance, to 0 volts. This operation is termed attempting to write a volatile "1". If the cell is in a non-volatile "1" state, the surface of the JFET source will be accumulated and the JFET source will be strongly capacitively coupled to the sense line contact 30 and the volatile write operation will result in the source being set in reverse bias with respect to the JFET drain or, silicon substrate. If the non-voltile 0 state had been previously written (the erase state), there would have been an inversion layer over the surface of the JFET source, resulting in an electrostatic shielding of the JFET source from the sense line contact 30; in this case, the result of the attempt to write a volatile "1" will have no effect on the JFET source potential and it will remain at substrate potential, for instance, 0 volts. The sense operation is completed by floating the sense line, by turning off the reset transistor 23 and then opening the selected cell JFET channel by lowering its word line 24 and JFET gate 18 to, for instance, 0 volts. If a volatile "1" state had been successively written, then the action of opening the JFET action will be to increase the JFET source voltage from its reverse bias to 0 volts. Since there is a large coupling capacitance between the JFET source and the bit line contact 30, the voltage of the floating bit line will rise to a value limited by the magnitude of the total parasitic capacitance on the selected bit line. If a volatile "1" had not been successively written, the act of opening the JFET channel will not change the JFET source voltage and the voltage step observed when a volatile "1" was successively written will not be observed. In summary, if a volatile "1" has been successively written, the memory insulator was in a non-volatile "1" state, if a volatile "1" state was not successively written, then the memory insulator was in a non-volatile "0" state. The storage time of the volatile state does not have to be as long as the corresponding volatile state in a dynamic RAM because the non-volatile data is stored in the memory insulator and the volatile write and read operations may quickly follow each other for instance within a few microseconds. In other words, the volatile state does not have to be maintained until the cell is reselected for sensing at a later time. This sense operation is described by the voltage waveforms of Figure 10 using the circuit of Figure 1. When a dynamic sense latch is used, two bit sense lines will be compared against each other with a dummy cell being activated in one sense line while a non-volatile JRAM is being sensed on the first sense line.

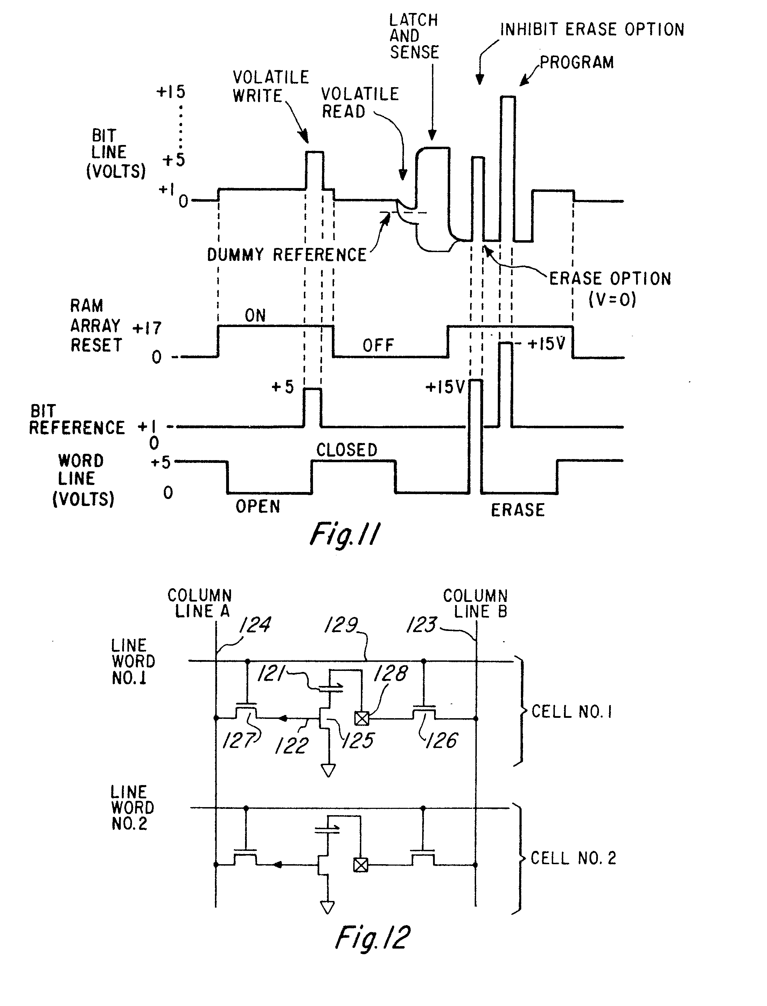

The memory construction using sense latches is shown in Figure 8. The dummy cells in Figure 8 may be JRAMS without a non-volatile insulator or may be a capacitor without non-volatile insulator. A dummy cell provides a sense signal at the sense latch which is of an amplitude intermediate to that produced by sensing the NVJRAM in the non-volatile "1" state and the non-volatile "0" state. Figure 11 shows the voltage waveforms when the array is operated with sense latches. In this design, writing a non-volatile "1" state can be accomplished through a reset MOSFET, as in Figures 1 and 8, or by increasing the voltage $V_D$ supplied to the sense latch when the bit is floated prior to the read operation and the word lines and dummy lines are opened for the second time. The voltage on the bit line will change slightly to a value determined by the non-volatile state with the non-volatile "1" state giving the larger voltage. The activation of the dummy causes the other bit line attached to the sense latch to go to a voltage intermediate between that given by the non-volatile "1" and "0" state as shown by the dashed line in Figure 11. The next step is to activate the sense latch which will then latch to a medium voltage, for instance, 5 volts, if the NVJRAM non-volatile state were 1 into a low voltage for instance, 0 volts if the state were 0. The state of the sense latch can now be interrogated. After interrogation, the state of the NVJRAM may be rewritten or reprogrammed or erased as shown in Figure 11. It should be noted that the latching voltage may be used to reinforce the non-volatile state which has been read. If the sense latch latches to 5 volts, this is in the proper direction to reinforce the 1 state which was read. If the sense latch latches to 0 volts, the non-volatile state was 0 and the state may be reinforced by increasing the voltage of the word line while keeping the selected bit line at 0 volts. The unselected bit lines must be taken to an intermediate voltage, for instance, 5 volts, in order to inhibit the erase or program a 0.

The structures and modes of operation described above are further modified, in the preferred embodiments which will now be described, to avoid possible disturbance of half selected cells. That is, when a cell is addressed for reading or writing, the information stored in other cells which share either a bit line or a column line with the cell addressed should not be disturbed.

Figure 12 is a schematic diagram of a further embodiment of two memory cells. In each cell is the MIS gate 121 and the JFET 125 and JFET gate 122, and two additional MOSFET's 126 and 127. These MOSFET's isolate the cell element from the column lines, thereby significantly reducing the disturbance of the cell element caused by programming and reading operations. MOSFET 126 isolates the MIS gate 121 from column line B (123).

MOSFET 127 isolates the JFET gate 122 from column line A
(124). The word line 129 for each cell couples the MOSFET
isolators (126 and 127) to a control signal. An inter
layer "via" 128 is required to connect the MIS gate 21 to
the MOSFET 126 source. This added feature of isolation
for the protection of the stored data comes at the expense
of having a physically larger cell. The two added
MOSFET's and the bus line to hook them up to a control
signal requires added area.

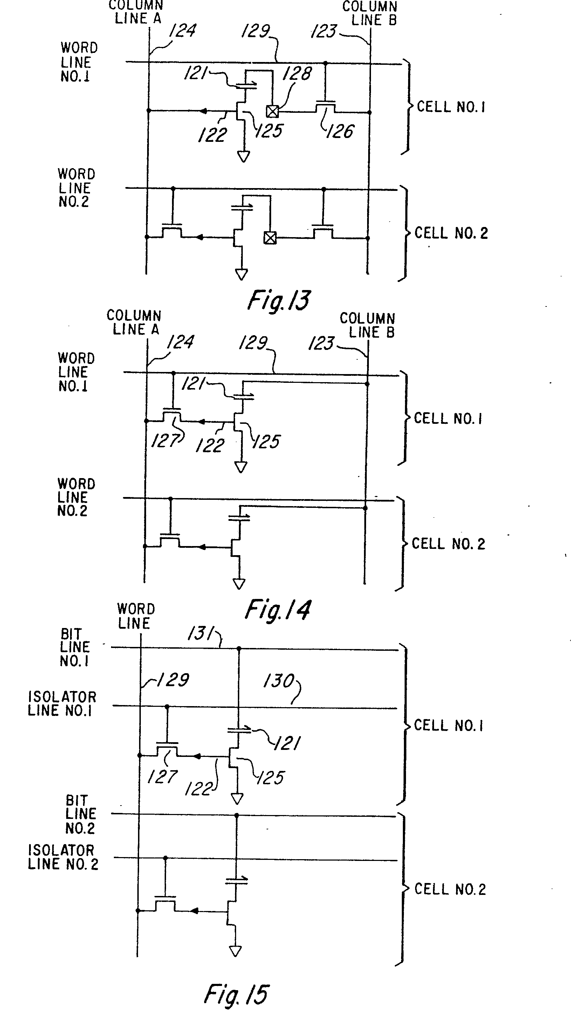

In Figure 13, there is shown a further embodiment of
the NVJRAM cell of the present invention. The column line
B (123) is isolated from the MIS gate 121 by MOSFET 126.
The column line A (124) is connected directly to the JFET
gate 122. In this embodiment, the addressing pulses on
column line B are isolated from the MIS gate 121 by the
MOSFET 126. Pulses from column line A also do not cause a
large voltage drop across the non-voltile insulator
because the MIS gate 121 node is isolated by the cut off
MOSFET 126 and thus this node is of low capacitance and
this node voltage tends to follow the pulse amplitude in
column A. The inter layer via is still required in this
embodiment of the present invention.

In Figure 14, a schematic diagram of another
simplified embodiment of the present invention is shown.
In this embodiment, column line A (124) is isolated from
the JFET gate 122 by MOSFET 127. Column line B (123) is
directly coupled to the MIS gate 121. In this embodiment,
the addressing pulses on column line A are isolated from
the JFET gate 122 by the MOSFET 127. A further advantage
of this embodiment is the programming inhibit tendency
provided by the low capacitance of the node at the
junction of the JFET gate electrode. This node has a very
low capacitance when the MOSFET is cut off and will tend
to follow the voltage variations at the column line B
junction with the MIS gate. This would reduce the voltage
appearing across the MIS gate, and therefore lower the
disturbance to the gate programmed state.

In Figure 15 is shown a schematic diagram of a cell
similar to the cell in Figure 14, but having a different type of addressing arrangement. In this embodiment, the MIS gate 121 is directly coupled to the bit line 131 and the JFET 125. The JFET gate 122 is isolated from the word line 129 by a MOSFET 127. The MOSFET control comes to the cell on the isolator control line 130. The difference in addressing arrangements will be mainly evident in the fabrication process of the cells. The read operation for the cell of this invention is accomplished the same as for the basic NVJRAM cell. Since reading involves pulsing of address lines, the present invention also provides protection against read disturb.

The present invention provides a novel method for protecting NVJRAM cell programmed states from being disturbed by the voltage pulses that appear on the cell address lines. The cell can be almost totally isolated, at the expense of each cell being physically larger, by addition of two MOSFET devices. The isolation thus provided will drastically reduce disturbance of data stored in the cell, whether it be from read or write operations.

If cell size is a critical factor, the isolation of the cell from one of its two address lines by an additional MOSFET device will mean a significant decrease in the cell disturbance caused by memory operations. The additional effect of capacitive behavior in the cell when protected by only one MOSFET device makes possible a large reduction in cell state disturbance for only a moderate increase in cell size.

While the focus of this invention has been on particular embodiments of the NVJRAM, it will be understood that the application to other types of non-volatile memory may become apparent to those skilled in the art without departing from the spirit and scope of the invention which is defined by the appended claims.

WHAT IS CLAIMED IS:

1. A nonvolatile data storage cell comprising:
   a semiconductor substrate of a first conductivity type;
   A JFET gate region, of a second conductivity type, at the surface of said substrate, wherein said JFET gate region surrounds an enclosed region of said substrate;
   an insulating layer covering the surface of said substrate;
   a multilayer dielectric structure overlying said enclosed substrate region and recessed into said insulating layer; and
   a conductive strip disposed on the surface of said insulating layer in contact with said multilayer dielectric structure.

2. The cell of Claim 1, wherein said enclosed region has a laterally elongated shape.

3. The data storage cell of Claim 2, further including a pair of spaced apart channel stop regions, of the same conductivity type as said substrate, underlying said insulating layer, said channel stop regions being disposed parallel and adjacent to said enclosed region.

4. The cell of Claim 1, wherein the portion of said enclosed region nearest said multilayer dielectric structure, has a region of higher impurity concentration.

5. The cell of Claim 1, wherein said JFET gate region comprises a surface which is coplanar with the portion of said enclosed region nearest said multilayer dielectric structure.

6.   The cell of Claim 1, further comprising a MOSFET series connected to said JFET gate region.

7.   The cell of Claim 1, further comprising a MOSFET series-connected to said conductive strip.

8.   An array of the memory cells of FIGURE 1, wherein adjacent ones of said cells comprise JFET gates which are included in a common region of said second conductivity type.

9.   A method for fabrication of a nonvolatile, random-access data storage cell, comprising the steps of:
    (a)   forming channels of one conductivity type separated by areas of the opposite conductivity type on a semiconductor substrate;
    (b)   constructing vertical JFET devices at spaced intervals along said channels;
    (c)   forming multi-dielectric stacks in such a proximity to the source region of each said JFET device so as to capacitively couple said multi-dielectric stacks to said source regions; and
    (d)   forming metal lines for interconnection of said cells with peripheral devices contained on said substrate.

10.  A memory device substantially as described and shown in the accompanying specification and drawings

Fig. 1

Fig. 3

Fig. 2

Fig. 4

STORAGE ELEMENT 15

26

22

24

18    P+    17    24

Fig.5

51  52        51  52

P+        P+

17

Fig.6a

59        59

53        53        53

54        54

Fig.6b

55  56  57    57  56  55        56  57  55

P+    P+

N+    N+    N+    N+    P+

P+        P+

Fig.6c

Fig.6d

Fig.6e

$C_{BW}$    $C_{INS}$    $C_S$    30 (MIS GATE)

$C_D$    32    14    18

(JFET GATE)    16

(A) INVERSION LAYER ON SURFACE OF JFET SOURCE

$C_{BW}$    $C_{INS}$    $C_S$    30 (MIS GATE)

14    18    16

(JFET GATE)

(B) ACCUMULATION LAYER ON SURFACE OF JFET SOURCE

Fig.7

Fig. 8

LATCH AND SENSE

"INHIBIT"-"
+15V

READ

PROGRAM "+"

+5V

MIS GATE/BIT LINE $^{+2}$

0 V

DUMMY REFERENCE

PROGRAM "-"

+17V — ON

PRESET LINE          OFF

15V

+15V

MIS SUPPLY

JFET GATE/WORD LINE — CLOSED

OPEN

PROGRAM

HIGH

LOW

Fig.9

ATTEMPT TO VOLATILE WRITE "I"

BIT      +
LINE   0
VOLTAGE

READ VOLATILE "I" ONLY IF
NON-VOLATILE I PROGRAMMED

VOLATILE
WRITE

OPERATIONS ON
OTHER BITS

OTHER BITS

WORD LINE
VOLTAGE      +
0

SHORT STORAGE
TIME FOR
VOLATILE STATE

TIME ALLOTTED
FOR PROGRAMMING
OR ENHANCING
N V STATE

Fig.10

6 / 7

0055110

Fig.11

Fig.12

7 / 7

COLUMN LINE A — 124    129    123 — COLUMN LINE B

WORD LINE NO.1

121    128

122    125    126

CELL NO.1

WORD LINE NO.2

CELL NO.2

Fig.13

COLUMN LINE A — 124    129    123 — COLUMN LINE B

WORD LINE NO.1

121

127    122    125

CELL NO.1

WORD LINE NO.2

CELL NO.2

Fig.14

WORD LINE

BIT LINE NO.1    131

129    130

ISOLATOR LINE NO.1    121

127    122    125

CELL NO.1

BIT LINE NO.2

ISOLATOR LINE NO.2

CELL NO.2

Fig.15